# EUROPÄISCHE PATENTSCHRIFT

(11) **EP 1 888 947 B1**
(45) Veröffentlichungstag und Bekanntmachung des Hinweises auf die Patenterteilung: **20.10.2010**
(21) Anmeldenummer: 06755007.9
(22) Anmeldetag: 04.05.2006
(51) Int. Cl.: F16H 61/00, B60R 16/02, H02K 9/10, F16H 57/04, F16H 59/72

(54) **ELEKTRONISCHES STEUERGERÄT FÜR EIN KRAFTFAHRZEUG, INSBESONDERE FÜR EINE GETRIEBESTEUERUNG**
ELECTRONIC CONTROLLER FOR A MOTOR VEHICLE, IN PARTICULAR FOR A GEARBOX CONTROLLER
APPAREIL DE COMMANDE ELECTRONIQUE POUR VEHICULE AUTOMOBILE, EN PARTICULIER POUR COMMANDE DE BOITE DE VITESSES

(30) Priorität: 08.06.2005 DE 20509039 U
(43) Veröffentlichungstag der Anmeldung: 20.02.2008
(73) Patentinhaber: Continental Automotive GmbH, 30165 Hannover (DE)
(72) Erfinder: MEYER, Martin, 65843 Sulzbach (DE)
(86) Internationale Anmeldenummer: PCT/EP2006/062047
(87) Internationale Veröffentlichungsnummer: WO 2006/131428

(56) Entgegenhaltungen:
- EP-A- 1 054 192
- DE-A1- 4 311 518
- DE-A1- 10 239 634
- DE-A1- 19 710 931
- DE-A1- 19 958 189
- US-A1- 2004 035 245
- US-A1- 2004 150 271
- US-B1- 6 488 601

## Beschreibung

Die Erfindung betrifft ein elektronisches Steuergerät für ein Kraftfahrzeug, insbesondere für eine Getriebesteuerung, welches in oder an einem Antriebsstrang angeordnet ist, bestehend aus einer in einem Gehäuse angeordneten Leiterplatte, die elektronische Bauelemente trägt, wobei zwischen der Leiterplatte und dem Gehäuse eine Elektronikwärmeschutzbarriere angeordnet ist.

Derartige Vorrichtungen sind aus der US 6,488,601 und der EP 1054192 A1 bekannt.

Aus der DE 102 39 634 A1 ist eine elektronische Steuereinrichtung bekannt, welche im Antriebsstrang eines Kraftfahrzeuges zwischen einer Brennkraftmaschine und einem Getriebe in einer Gehäuseglocke angeordnet ist. Da allerdings im Innenraum der Gehäuseglocke durch die Wärme der Brennkraftmaschine und durch die Wärme von Aktuatoren eine hohe Temperatur entsteht, die die elektronischen Bauteile der Steuereinrichtung zerstören könnte, ist eine Kühlung mit Druckluft vorgesehen. Dazu ist das Steuergerät in einem Luftbypass angeordnet und wird von der zur Betätigung des Aktuators genutzten Druckluft umströmt. Da diese Kühlung nicht ausreicht, ist zusätzlich ein Peltier-Element am Steuergerät angeordnet, dessen kalte Seite dem Steuergerät zugekehrt ist und die dadurch die elektronischen Bauteile kühlt. Darüber hinaus sind noch Kühlrippen an dem Steuergerät ausgebildet.

Trotz dieser Maßnahmen zur Kühlung kommt es zu Ausfällen dieser elektronischen Bauteile, da solche Bauteile nicht für so extrem hohe Dauertemperaturen ausgelegt sind.

Der Erfindung liegt somit die Aufgabe zugrunde, ein Steuergerät anzugeben, welches auch einem extrem hohen Temperaturniveau am Einbauort standhält und eine zuverlässige Funktion der Elektronik gewährleistet.

Erfindungsgemäß ist die Aufgabe dadurch gelöst, dass das Kühlmittel Druckluft ist und der Kühlmitteleinlass als Ventil ausgebildet ist, wobei das Ventil mit einer, den Kühlmitteleintritt in Abhängigkeit von der Gehäuseinnentemperatur steuernden Elektronik verbunden ist.

Die Erfindung hat den Vorteil, dass die Kühlung unmittelbar in der Nähe der elektronischen Bauelemente selbst erfolgt. Durch die im Gehäuse selbst angeordnete Wärmebarriere wird gewährleistet, dass die aus der Umgebung in das Steuergerät eindringende Wärme sofort abgeführt wird und gar nicht erst auf die Bauelemente wirkt. Auf diese Art und Weise ist es einfach möglich, die Betriebstemperatur der elektronischen Bauelemente zu gewährleisten. Zudem lässt sich durch die Erfindung die Kühlung nach Bedarf ein- und ausschalten.

Auf Grund der Erfindung ist die Funktion der Elektronik des Steuergerätes bei Dauertemperaturen bis 130 °C und Spitzentemperaturen bis 150 °C ohne Systemausfall gewährleistet.

In einer vorteilhaften Ausgestaltung ist die Wärmeschutzbarriere als Kühlelement ausgebildet, in welchem ein Kühlmittel geführt ist. Durch die Führung des Kühlmittels wird die von außen aufgenommene Wärme sofort aus dem Gehäuse des Steuergerätes abgeführt.

Dadurch, dass das Kühlelement röhrenartig ausgebildet ist und über einen Kühlmitteleinlass mit einem Kühlmittelreservoir verbunden ist, wird das erwärmte Kühlmittel abgeführt und kühleres Kühlmittel aus dem Reservoir nachgeführt. Alternativ wird der Kühlmitteleinlass mit einem Ventil angesteuert, welches mit der, den Kühlmitteleintritt in Abhängigkeit von der Gehäuseinnentemperatur steuernden Elektronik verbunden ist.

In einer Weiterbildung ist am Gehäuse ein Kühlmittelauslass angeordnet. Die Führung des Kühlmittels erfolgt dabei vom Kühlmitteleinlass über das Kühlelement durch das Gehäuse und wird von hier an die Umgebung abgegeben.

Vorteilhafterweise kann das Kühlsystem ein Druckluftsystem, ein Hydrauliksystem oder ein Kraftstoffsystem sein.

In einer Ausgestaltung ist zwischen dem Kühlelement und der Leiterplatte eine temperaturleitende Kunststofffolie angeordnet. Eine solche Kunststofffolie trägt zusätzlich dazu bei, die Umgebungstemperatur von der Elektronik fernzuhalten.

Auf Grund der im Steuergerät selbst angeordneten Elektronikwärmeschutzbarriere ist es möglich, dass das Steuergerät mit dem Antriebsstrang eine gemeinsame Ummantelung aufweist. Diese Ummantelung dient der Herabsetzung des Geräuschpegels, verhindert aber auf der anderen Seite die Wärmeabfuhr durch das Gehäuse.

Um den Wärmeschutz innerhalb des Steuergerätes zu erhöhen, umgibt die Elektronikwärmeschutzbarriere die Leiterplatte beidseitig.

Die Erfindung lässt zahlreiche Ausführungsmöglichkeiten zu. Eine davon soll anhand der in der Zeichnung dargestellten Figur näher erläutert werden. Es zeigen:
- Figur 1: ein Getriebesteuergerät am Getriebe des Kraftfahr- zeuges,
- Figur 2: das Getriebesteuergerät im geschlossenen Zustand,
- Figur 3: eine Explosionsdarstellung des Getriebesteuergerä- tes.

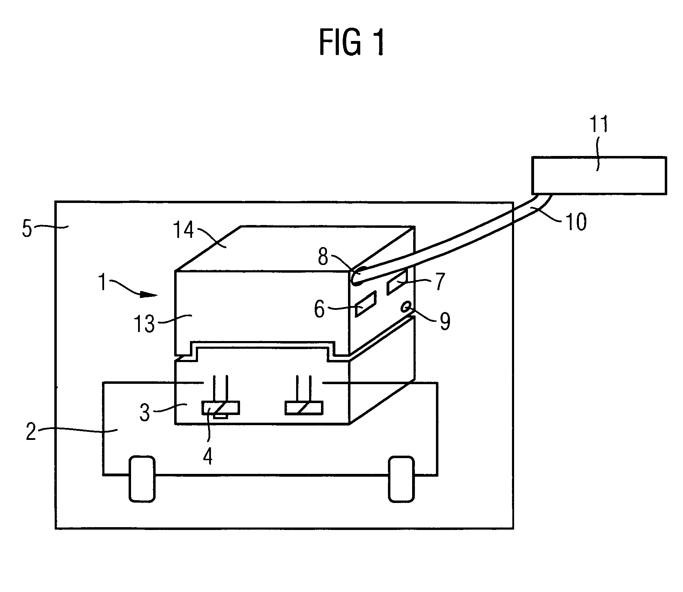

In Figur 1 ist das Getriebesteuergerät 1 am Getriebe 2 eines nicht weiter dargstellten Antriebsstrangs eines Kraftfahrzeuges angeordnet. Zum Antriebstrang gehören der Verbrennungsmotor, die Kupplung, das Getriebe und/ oder ein Retarder, wobei das Steuergerät 1 auch an diesen Baugruppen angeordnet sein kann.

Das Getriebe 2 weist einen Aktuatorblock 3 mit Aktuatoren 4 auf, wobei das Steuergerät 2 auf dem Aktuatorblock 3 aufgesetzt ist. Das Steuergerät 1, das Getriebe 2 und der Aktuatorblock 3 sind aus Lärmschutzgründen mit einer Ummantelung 5 umgeben.

Das Getriebesteuergerät 1 weist neben zwei Steckerleisten 6 und 7, ein Lufteinlassventil 8 und ein Luftauslassventil 9 auf. Das Lufteinlassventil 8 ist über eine Druckluftleitung 10 mit einem Druckluftreservoir 11 verbunden.

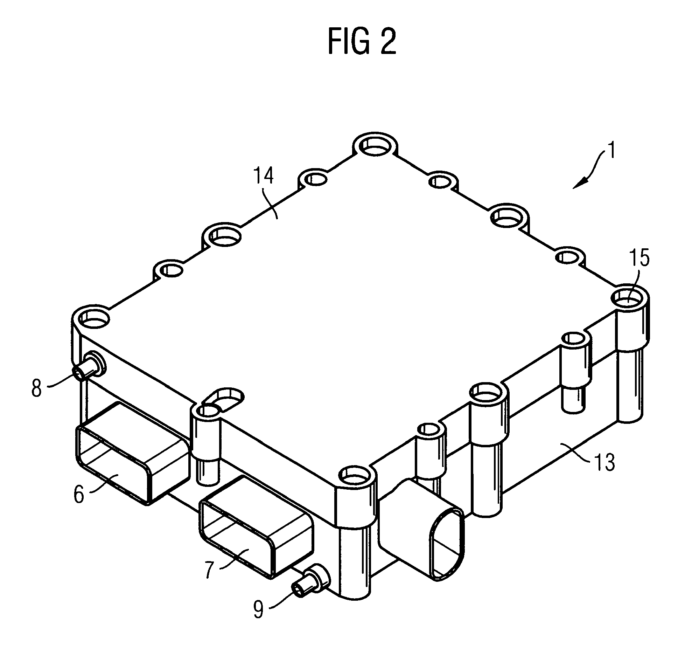

In Figur 2 ist das Getriebesteuergerät im geschlossenen Zustand dargestellt. Auch hier sind das Drucklufteinlassventil 8 und ein Druckluftauslasselement 9 zu erkennen. Dabei ist das Gehäuse zweiteilig ausgebildet und besteht aus einem Kunststoffgrundkörper 13, welcher mit einem Kunststoffoberteil 14, abgedeckt ist. Über mehrere Schraubverbindungen 15 sind der Grundkörper 13 und die Abdeckung 14 miteinander verbunden.

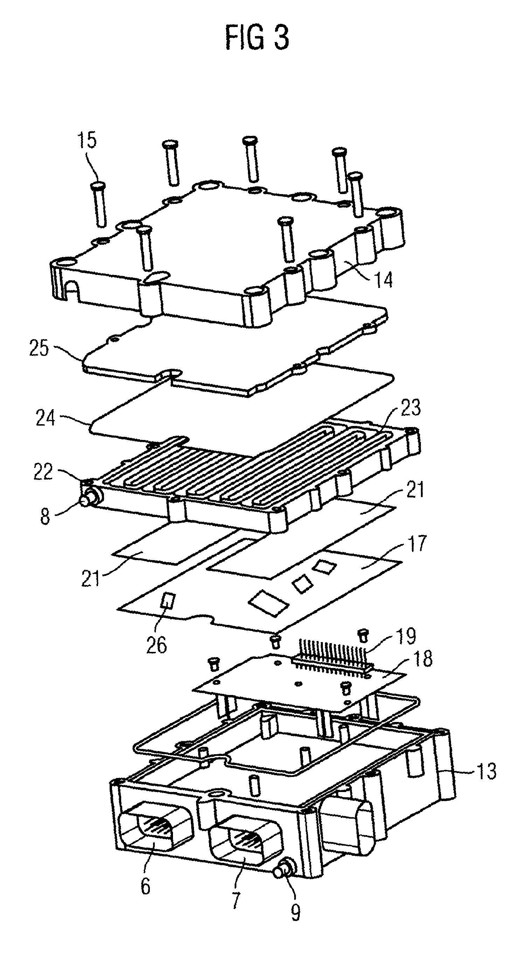

Gemäß Figur 3 ist in dem Grundkörper 13 eine Leiterplatte 17 eingelegt, die eine Elektronik trägt. Die Leiterplatte 17 ist über ein Verbindungselement 19 in Form eines Steckers mit einer weiteren, Elektrik tragende Leiterplatte 18 verbunden, welche die Ventile 8, 9 kontaktiert. An eine Kälteleitfolie 21 schließt sich ein aus Aluminium bestehendes Kühlelement 22 an, dessen Kühlmittel führende Röhren 23 mäanderförmig verlegt sind. An dieses Kühlelement 22 schließen sich eine Dichtung 24 und ein Hitzeschild 25 an. Das Kühlelement 22 wird bei der Montage mit dem Grundkörper 13 und der Abdeckung 14 mittels Schrauben 15 zu einer baulichen Einheit verschraubt.

Das Presslufteinlassventil 8 ist dabei an dem Kühlelement 22 und das Luftauslasselement 9 am Trägerkörper 13 angeordnet.

Die Pressluft wird durch das Einlassventil 8 über die mäanderförmigen Kühlschlangen 23 des Kühlelementes 22 geführt und fließt durch nicht weiter dargestellte Öffnungen im Kühlelement 22 und der Elektronik 17 und verlässt das Gehäuse über das Luftauslasselement 9 im Grundkörper 13.

Dieses Kühlsystem ermöglicht eine Kühlung des Steuergerätes 1 durch das Aluminiumkühlelement 22 mit Pressluft eines an sich im Fahrzeug vorhandenen Pressluftsystems. Die mäanderförmigen Kühlschlangen 23 des Kühlelementes 22 garantieren einen ausreichenden Temperaturabfall von der Umgebung zu der Elektronik. Die Kunststofffolie 21 verstärkt diesen Temperaturgradienten durch Übertragung der Kühlleistung vom Kühlelement 22 auf die Elektronik.

Über einen Temperatursensor 26 wird die aktuelle Temperatur der Elektronik intern gemessen und an einen Mikrocontroller, welcher sich ebenfalls auf der Leiterplatte 17 befindet, analysiert. Dieser Mikrocontroller entscheidet, ob das Ventil 8 angesteuert wird. Diese Steuerung ermöglicht eine Energiereduzierung, da die Pressluft nur dann in den Kühlkörper 22 geleitet wird, wenn die Temperaturverhältnisse innerhalb des Steuergerätes 1 dies erfordern, um die Funktionsweise der elektronischen Bauelemente aufrechtzuerhalten.

## Patentansprüche

1. Elektronisches Steuergerät für ein Kraftfahrzeug, insbesondere für eine Getriebesteuerung, welches in oder an einem Antriebsstrang angeordnet ist, bestehend aus einer in einem Gehäuse angeordneten Leiterplatte, die elektronische Bauelemente trägt, wobei zwischen der Leiterplatte (17)und dem Gehäuse (13, 14) eine Elektronikwärmeschutzbarriere (22) angeordnet ist, , **dadurch gekennzeichnet, dass** das Kühlmittel Druckluft ist und der Kühlmitteleinlass (8) als Ventil ausgebildet ist, wobei das Ventil mit einer, dem Kühlmitteleintritt in Abhängigkeit von der Gehäuseinnentemperatur steuernden Elektronik (18) verbunden ist.

2. Steuergerät nach Anspruch 1, **dadurch**
**gekennzeichnet, dass** die Wärmeschutzbarriere (22) als Kühlelement ausgebildet ist, in welchem ein Kühlmittel geführt ist.

3. Steuergerät nach Anspruch 2, **dadurch gekennzeichnet, dass** das Kühlelement röhrenartig ausgebildet ist und über einen Kühlmitteleinlass (8) mit einem Kühlmittelreservoir (11) verbunden ist.

4. Steuergerät nach Anspruch 3, **dadurch**
**gekennzeichnet, dass** der Kühlmitteleinlass (8) von einem Ventil angesteuert wird, welches mit der, dem Kühlmitteleintritt in Abhängigkeit von der Gehäuseinnentemperatur steuernden Elektronik (18) verbunden ist.

5. Steuergerät nach Anspruch 1, **dadurch**
**gekennzeichnet, dass** ein Kühlmittelauslass (9) am Gehäuse angeordnet ist.

6. Steuergerät nach einem der Ansprüche 2 oder 3,
**dadurch gekennzeichnet dass** zwischen dem Kühlelement (22) und der Leiterplatte (17) eine temperaturleitende Folie (21) angeordnet ist.

7. Steuergerät nach einem der vorhergehenden Ansprüche,
**dadurch gekennzeichnet, dass** es eine gemeinsame Ummantelung (5) mit dem Antriebsstrang (2) aufweist.

8. Steuergerät nach Anspruch 1, **dadurch gekennzeichnet, dass** die Elektronikwärmeschutzbarriere 22) die Leiterplatte (17) beidseitig umgibt.

## Claims

1. Electronic controller for a motor vehicle, in particular for a gearbox controller, which is arranged in or on a drive train, composed of a printed circuit board which is arranged in a housing and which is fitted with electronic components, an electronic heat protection barrier (22) being arranged between the printed circuit board (17) and the housing (13, 14), **characterized in that** the coolant is compressed air and the coolant inlet (8) is embodied as a valve, the valve being connected to an electronic system (18) which controls the entry of coolant as a function of the internal temperature of the housing.

2. Controller according to Claim 1, **characterized in that** the heat protection barrier (22) is embodied as a cooling element in which a coolant is conducted.

3. Controller according to Claim 2, **characterized in that** the cooling element is of tubular design and is connected to a coolant reservoir (11) via a coolant inlet (8).

4. Controller according to Claim 3, **characterized in that** the coolant inlet (8) is actuated by a valve which is connected to the electronic system (18) which controls the entry of coolant as a function of the internal temperature of the housing.

5. Controller according to Claim 1, **characterized in that** a coolant outlet (9) is arranged on the housing.

6. Controller according to one of Claims 2 or 3, **characterized in that** a heat-conducting film (21) is arranged between the cooling element (22) and the printed circuit board (17).

7. Controller according to one of the preceding claims, **characterized in that** said controller has a common outer casing (5) with the drive train (2).

8. Controller according to Claim 1, **characterized in that** the electronic heat protection barrier (22) surrounds the printed circuit board (17) on both sides.

## Revendications

1. Appareil électronique de commande pour véhicule automobile, notamment pour la commande d'une boîte de vitesses placée dans ou sur une ligne de transmission moteur, ledit appareil électronique étant composé d'une carte à circuits imprimés, montée dans un boîtier et portant des composants électroniques, alors qu'une barrière (22) de protection thermique de l'électronique est disposée entre la carte à circuits imprimés (17) et le boîtier (13, 14), **caractérisé par le fait que** le réfrigérant est de l'air comprimé et l'entrée (8) de réfrigérant est conçue sous forme de soupape, où la soupape est reliée à un système électronique (18) qui commande l'entrée de réfrigérant en fonction de la température à l'intérieur du boîtier.

2. Appareil de commande selon la revendication 1, **caractérisé par le fait que** la barrière de protection thermique (22) est conçue sous forme d'organe réfrigérant dans lequel circule un réfrigérant.

3. Appareil de commande selon la revendication 2, **caractérisé par le fait que** l'organe réfrigérant est en forme de tube et est relié à un réservoir de réfrigérant (11) par l'intermédiaire d'une entrée de réfrigérant (8).

4. Appareil de commande selon la revendication 3, **caractérisé par le fait que** l'entrée de réfrigérant (8) est commandée par une soupape reliée à un système électronique (18) qui commande l'entrée de réfrigérant en fonction de la température à l'intérieur du boîtier.

5. Appareil de commande selon la revendication 1, **caractérisé par le fait qu**'une sortie (9) de réfrigérant est disposée sur le boîtier.

6. Appareil de commande selon l'une des revendications 2 ou 3, **caractérisé par le fait qu**'une membrane (21) à conduction thermique est placée entre l'organe réfrigérant (22) et la carte à circuits imprimés (17).

7. Appareil de commande selon l'une des revendications précédentes, **caractérisé par le fait qu**'il a une gaine (5) commune avec la ligne de transmission moteur (2).

8. Appareil de commande selon la revendication 1, **caractérisé par le fait que** la barrière de protection thermique (22) de l'électronique entoure la carte à circuits imprimés (17) des deux côtés.
